(19) Europäisches Patentamt
European Patent Office
Office européen des brevets

(11) **EP 2 031 650 A2**

(12) **EUROPÄISCHE PATENTANMELDUNG**

(43) Veröffentlichungstag:
**04.03.2009 Patentblatt 2009/10**

(51) Int Cl.:
***H01L 21/66*** *(2006.01)*

(21) Anmeldenummer: 08015105.3

(22) Anmeldetag: **27.08.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **27.08.2007 DE 102007040650**

(71) Anmelder: **Fraunhofer-Gesellschaft zur Förderung der Angewandten Forschung e.V. 80686 München (DE)**

(72) Erfinder:
• **Spitz, Meinrad**
**79111 Freiburg (DE)**
• **Rein, Stefan**
**79211 Denzlingen (DE)**

(74) Vertreter: **Lemcke, Brommer & Partner Patentanwälte Bismarckstrasse 16 76133 Karlsruhe (DE)**

(54) **Verfahren zur induktiven Messung eines Schichtwiderstandes einer in einen multikristallinen Halbleiterwafer eingebrachten Dotierungsschicht**

(57) Die Erfindung betrifft ein Verfahren zur induktiven Messung eines Schichtwiderstandes einer in einen multikristallinen Halbleiterwafer (1) eingebrachten Dotierungsschicht (2), insbesondere einer in einen multikristallinen Siliziumwafer eingebrachten Dotierungsschicht, folgende Verfahrensschritte umfassend:

A Bestimmen des Basisschichtwiderstandes $R_B$ des Halbleiterwafers
(1) mittels einer induktiven Messmethode,

B Bestimmen des Parallelschichtwiderstandes $R_P$ des Halbleiterwafers (1) mittels einer induktiven Messmethode, nachdem die Dotierungsschicht (2) eingebracht wurde,

C Berechnen des Schichtwiderstandes $R_D$ der eingebrachten Dotierungsschicht (2) abhängig von $R_B$ und $R_P$.

Wesentlich ist, dass der Verfahrensschritt A vor Einbringen der Dotierungsschicht (2) und vor einer Behandlung des Halbleiterwafers (1), welche Potentialbarrieren an den Korngrenzen erzeugen kann, durchgeführt wird und/oder nach Einbringen der Dotierungsschicht (2) in den Halbleiterwafer (1) durchgeführt wird.

# Figur 1b

EP 2 031 650 A2

**Beschreibung**

Die Erfindung betrifft ein Verfahren zur Messung eines Schichtwiderstandes einer in einen multikristallinen Halbleiterwafer eingebrachten Dotierungsschicht, insbesondere einer in einen multikristallinen Siliziumwafer eingebrachten Dotierungsschicht, gemäß dem Oberbegriff des Anspruchs 1.

Elektronische Bauteile werden typischerweise dadurch hergestellt, dass in einen Halbleiterwafer Dotierungsschichten eingebracht werden. Häufig ist der Halbleiter bereits mit einer Dotierung eines bestimmten Typs homogen dotiert und anschließend wird mit einer elektrisch entgegengesetzten Dotierung eine Dotierungsschicht eingebracht, so dass beispielsweise eine Diode entsteht. Ebenso ist es bekannt, bei einem bereits homogen dotierten Halbleiter eine Dotierungsschicht einzubringen, die elektrisch gleichartig dotiert ist, jedoch in einer höheren Dotierkonzentration, z.B. zur Herstellung so genannter "back surface fields" bei Solarzellen.

Insbesondere bei der Herstellung von Silizium-Solarzellen wird typischerweise von einem homogen p-dotierten multikristallinen Siliziumwafer ausgegangen, auf den anschließend an mindestens einer Oberfläche eine n-dotierte Dotierungsschicht z.B. mittels Diffusion eingebracht wird, so dass ein Emitter entsteht und sich zwischen Emitter und dem restlichen Siliziumwafer (der sogenannten Basis) ein pn-Übergang ausbildet. Ebenso ist auch die elektrisch umgekehrte Vorgehensweise möglich, d.h. Einbringen eines p-dotierten Emitters in einen homogen n-dotierten Siliziumwafer.

Eine wesentliche physikalische Größe zur Charakterisierung der in den Halbleiterwafer eingebrachten Dotierungsschicht ist der Schichtwiderstand dieser Dotierungsschicht. Mittels des Schichtwiderstandes kann beispielsweise der Querleitungswiderstand für Ladungsträger berechnet werden, welche sich parallel zur Oberfläche des Halbleiterwafers bewegen.

Bei der an sich bekannten induktiven Messmethode wird mittels der Erzeugung von Wirbelströmen in dem zu vermessenden Halbleiterwafer der Schichtwiderstand bestimmt, vgl. beispielsweise D. K. Schroder, "Semiconductor material and device characterization", John Wiley & Sons, New York, 1990, S. 27-30.

Typischerweise wird mittels einer Spule eines elektromagnetischen Schwingkreises ein Wirbelstrom in dem zu vermessenden Halbleiter erzeugt. Abhängig von der Dämpfung des Schwingkreises nach Einbringen des Halbleiterwafers in das elektromagnetische Feld der Spule wird der Schichtwiderstand berechnet.

Bei der induktiven Schichtwiderstandsmessung ist bekannt, dass zur Bestimmung des Schichtwiderstandes einer eingebrachten Dotierungsschicht unmittelbar vor Eindiffundieren der Dotierungsschicht zunächst der Basisschichtwiderstand des Halbleiterwafers gemessen werden muss. Anschließend wird die Dotierungsschicht, wie beispielsweise der Emitter, mittels eines Diffusionsprozesses eindiffundiert und es wird erneut eine Schichtwiderstandsmessung durchgeführt.

Diese zweite Schichtwiderstandsmessung misst den Parallelschichtwiderstand des Halbleiterwafers, der sowohl von dem Schichtwiderstand der Basis des Halbleiters, als auch von dem Schichtwiderstand der eingebrachten Dotierungsschicht beeinflusst ist.

Aus dem gemessenen Basisschichtwiderstand vor Einbringen der Dotierungsschicht und dem gemessenen Parallelschichtwiderstand nach Einbringen der Dotierungsschicht wird der Schichtwiderstand der eingebrachten Dotierungsschicht berechnet.

Untersuchungen der Anmelderin haben gezeigt, dass das bekannte induktive Messverfahren häufig ungenaue oder sogar extrem abweichende bzw. unbrauchbare Messergebnisse (Messartefakte) für multikristalline Halbleiterwafer liefert. Insbesondere bei der Vermessung einer in einen multikristallinen Siliziumwafer eingebrachten Dotierungsschicht wurden starke Abweichungen von den theoretisch erwarteten Schichtwiderständen bzw. von den mittels Referenzmethoden gemessenen Schichtwiderständen aufgefunden.

Der Erfindung liegt daher die Aufgabe zugrunde, das bekannte Verfahren zur induktiven Messung eines Schichtwiderstandes dahingehend zu verbessern, dass Messartefakte bei der Bestimmung des Schichtwiderstandes der in einen Halbleiterwafer eingebrachten Dotierungsschicht vermieden und Messfehler verringert werden. Weiterhin soll sich das erfindungsgemäße Verfahren durch eine einfache und kostengünstige Anwendbarkeit auszeichnen.

Gelöst ist diese Aufgabe durch ein Verfahren zur Messung eines Schichtwiderstandes einer in einen multikristallinen Halbleiterwafer eingebrachten Dotierungsschicht gemäß Anspruch 1. Vorteilhafte Ausgestaltungen des erfindungsgemäßen Verfahrens finden sich in den Ansprüchen 2 bis 13.

"Multikristalliner Halbleiterwafer" bezeichnet dabei alle Halbleiterwafer, welche mindestens eine Korngrenze aufweisen. Dies sind insbesondere als "mc-Si" bekannte multikristalline Siliziumwafer, ebenso jedoch auch Halbleiterwafer mit einer sehr hohen Dichte an Korngrenzen, z.B. so genannte "mikrokristalline" Siliziumwafer.

Auch bei dem erfindungsgemäßen Verfahren wird somit in einem Schritt A der Basisschichtwiderstand $R_B$ des Halbleiterwafers gemessen. In einem Schritt B wird der Parallelschichtwiderstand $R_P$ des Halbleiterwafers gemessen, nachdem die Dotierungsschicht in den Halbleiterwafer eingebracht wurde und in einem Schritt C wird aus den Messwerten $R_B$ und $R_P$ der Schichtwiderstand $R_D$ der eingebrachten Dotierungsschicht bestimmt.

Wesentlich ist, dass der Verfahrensschritt A vor Einbringen der Dotierungsschicht und vor einer Behandlung des Halbleiterwafers, welche als unerwünschten Nebeneffekt Potentialbarrieren an den Korngrenzen erzeugen kann, durchgeführt wird und/oder, dass der Verfahrensschritt A nach Einbringen der Dotierungsschicht in den Halbleiterwafer durchgeführt wird.

Der Erfindung liegt die Erkenntnis der Anmelderin zugrunde, dass Messartefakte oder Messfehler bei der Messung des Schichtwiderstandes der Dotierungsschicht durch Potentialbarrieren an den Korngrenzen herbeigeführt werden, welche während der Behandlung des Halbleiterwafers hervorgerufen werden können. Weiterhin konnte die Anmelderin feststellen, dass diese Potentialbarrieren, welche Messfehler oder Messartefakte hervorbringen, durch das Einbringen der Dotierungsschicht wieder derart modifiziert werden, dass eine Verfälschung der Messergebnisse nach Einbringen der Dotierungsschicht wiederum unterbleibt oder zumindest vernachlässigbar ist.

Um Messfehler oder Messartefakte zu vermeiden ist es somit wesentlich, dass entweder vor einer Behandlung des Halbleiterwafers, welche Potentialbarrieren an den Korngrenzen erzeugt, der Basisschichtwiderstand des Halbleiterwafers gemessen wird oder dass diese Messung erst nach Einbringen der Dotierungsschicht in den Halbleiterwafer erfolgt.

Selbstverständlich liegt es auch im Rahmen der Erfindung, sowohl vor der genannten Behandlung des Halbleiterwafers, als auch nach Einbringen der Dotierungsschicht jeweils den Basisschichtwiderstand zu messen und diese Messergebnisse beispielsweise zu mitteln, um eine höhere Genauigkeit zu erreichen.

Behandlungen des Halbleiterwafers, die zu einer Erzeugung von Potentialbarrieren führen können sind insbesondere Ätzprozesse an dem Halbleiterwafer, nasschemische Behandlungen des Halbleiterwafers und Reinigungsschritte. So konnte durch die Anmelderin beispielsweise nachgewiesen werden, dass ein Reinigungsschritt, bei dem der Halbleiterwafer in etwa 70° Celsius warmes DI-Wasser (deionisiertes Wasser) getaucht und anschließend durch Anblasen mit Luft getrocknet wird, zu einem Aufbau von Potentialbarrieren an Korngrenzen führen kann.

Ätzprozesse sind z.B. das Abtragen von Halbleitermaterial des Halbleiterwafers in sauren oder alkalischen Ätzbädern, ebenso auch durch trockene Ätzverfahren, wie z.B. Plasmaätzen.

Nasschemische Behandlungen sind Material abtragende oder nicht Material abtragende Behandlungen des Halbleiterwafers in sauren, neutralen oder alkalischen Bädern. Dabei ist es unerheblich, ob die Wafer vollständig eingetaucht werden oder die Lösungen gezielt auf die Oberfläche aufgebracht werden.

Reinigungsschritte sind nasschemische oder nicht nasschemische Behandlungen, bei denen unerwünschte Substanzen von der Waferoberfläche entfernt werden. So werden z.B. durch eine so genannte RCA Reinigung, bestehend aus zwei Teilschritten, der SC1- und SC2-Reinigung, in einem Bad aus Ammoniumhydroxid, Wasserstoffperoxid und DI-Wasser (SC-1 Reinigung) bzw. einem Bad aus Salzsäure, Wasserstoffperoxid und DI-Wasser (SC-2 Reinigung) die Wafer von organischen bzw. anorganischen Verunreinigungen befreit. Bestandteil einer solchen Reinigung sind in der Regel Spülungen in z.B. DI-Waser sowie Trocknungsschritte. Ein Trocknungsschritt kann z.B. nach einem nassen Bad durch Lagern oder Abblasen der Restfeuchtigkeit mit Sauerstoff, Stickstoff oder einem anderen Gas erfolgen.

Die Untersuchungen der Anmelderin legen nahe, dass insbesondere das Abblasen des Halbleiterwafers für das Entstehen der Potentialbarrieren relevant sein kann. Vorteilhafterweise ist die zuvor genannte Behandlung des Halbleiterwafers, welche als unerwünschten Nebeneffekt Potentialbarrieren an den Korngrenzen erzeugen kann, daher eine Behandlung, welche das Abblasen des Halbleiterwafers umfasst, insbesondere das Abblasen mit Sauerstoff, Stickstoff oder einem anderen Gas. Dies beinhaltet insbesondere das Abblasen einer Restfeuchtigkeit.

So konnte die Anmelderin z.B. weiterhin nachweisen, dass bei der Behandlung eines multikristallinen Siliziumwafers durch nasschemische Ätzprozesse oder durch Eintauchen in ein HF-Bad (Flusssäurebad) als unerwünschter Nebeneffekt Potentialbarrieren an den Korngrenzen entstehen können.

Durch das erfindungsgemäße Verfahren wird somit eine Messung des Basisschichtwiderstandes des Halbleiterwafers zwischen der Erzeugung von Potentialbarrieren an den Korngrenzen durch eine Behandlung des Halbleiterwafers und dem Einbringen der Dotierungsschicht vermieden, da bei Vorhandensein der Potentialbarrieren nach Erkenntnissen der Anmelderin keine sinnvolle Messung des Basisschichtwiderstandes möglich ist oder zumindest die Messung mit einem hohen Messfehler behaftet ist.

Eine mögliche Erklärung ist, dass durch die Behandlung des Halbleiterwafers die Potentialbarrieren aufgebaut werden, welche bei der Messung des Schichtwiderstandes zu erhöhten Werten führen. Diese Potentialbarrieren werden durch Eindiffundieren der Dotierungsschicht jedoch ganz oder zumindest teilweise wieder unterbunden, so dass nach Einbringen der Dotierungsschicht (ebenso wie vor der Behandlung des Halbleiterwafers) keine Erhöhung des Schichtwiderstandes der Dotierungsschicht aufgrund von Potentialbarrieren vorliegt. Die Verfälschung von Messungen durch Potentialbarrieren ist insbesondere bei der Verwendung einer Messmethode plausibel, welche Ströme erzeugt, die parallel zur Oberfläche des Halbleiterwafers fließen. Denn für solche Ströme können die Potentialbarrieren an den Korngrenzen einen erhöhten elektrischen Leitungswiderstand darstellen, so dass sich z.B. ein erhöhter Schichtwiderstand aus der Messung ergibt. Solch eine Messmethode ist insbesondere die induktive Schichtwiderstandsmessung, bei der Wirbelströme erzeugt werden, die im Wesentlichen parallel zur Oberfläche des Halbleiterwafers fließen.

Insbesondere bei multikristallinen Siliziumwafern konnte die Anmelderin nachweisen, dass an den Korngrenzen eines unbehandelten Siliziumwafers geringfügige, vernachlässigbare Potentialbarrieren bestehen, welche jedoch nach einer nasschemischen Behandlung erheblich anwachsen und zu erhöhten Schichtwiderstandswerten führen. Diese Potentialbarrieren werden jedoch durch das Einbringen, insbesondere das Eindiffundieren der Dotierungsschicht ganz oder zumindest im Wesentlichen wieder eliminiert.

Bei der Herstellung von elektronischen Bauteilen stellt typischerweise ein Halbleiterwafer das Ausgangsmaterial dar. Der Halbleiterwafer wird typischerweise mittels eines Sägevorgangs von einem Halbleiterblock abgesägt und besitzt in etwa die Form einer flachen, in etwa kreisförmigen oder rechteckigen Scheibe.

An der Oberfläche weist der Halbleiterwafer nach dem Sägevorgang eine Schicht auf, deren Kristallstruktur ganz oder teilweise zerstört ist und deren Oberfläche rau ist. Dieser so genannte "Sägeschaden" wird üblicherweise durch eine nasschemische Behandlung, insbesondere durch Ätzvorgänge in einem Säure- oder Laugenbad beseitigt.

Nach Beseitigen dieses Sägeschadens wird mittels Einbringen von Dotierungsschichten, insbesondere durch Diffusion das gewünschte elektronische Bauteil hergestellt.

Mittels des erfindungsgemäßen Verfahrens ist es nun erstmals möglich, bei solch einem Herstellungsprozess eine präzise induktive Messung des Schichtwiderstandes der in den Halbleiterwafer eingebrachten Dotierungsschicht zu erhalten, indem vor der Behandlung des Halbleiterwafers, welche Potentialbarrieren erzeugen kann, insbesondere vor der nasschemischen Beseitigung des Sägeschadens, der Basisschichtwiderstand gemessen wird und/oder nach Einbringen der Dotierungsschicht der Basisschichtwiderstand gemessen wird.

Ein weiterer Vorteil des erfindungsgemäßen Verfahrens liegt darin, dass das Verfahren ohne Abänderung sowohl bei multikristallinen, als auch bei monokristallinen Halbleiterwafern angewendet werden kann. Das Verfahren kann somit auch in eine Produktionslinie integriert werden, in der beide Waferarten bearbeitet werden.

In einer vorteilhaften Ausführungsform des erfindungsgemäßen Verfahrens wird der Verfahrensschritt A vor Einbringen der Dotierungsschicht und vor einer Behandlung des Halbleiterwafers, welche Potentialbarrieren erzeugen kann, durchgeführt. Weiterhin wird in Verfahrensschritt C der Schichtwiderstand $R_D$ der eingebrachten Dotierungsschicht zusätzlich abhängig von einem bei der Behandlung des Halbleiterwafers erfolgten Materialabtrag korrigiert.

Wie vorhergehend beschrieben, dient typischerweise eine nasschemische Behandlung des Wafers dazu, die sägeraue Oberfläche des Wafers abzutragen. Vorteilhafterweise wird hierbei gleichzeitig auch eine Texturierung der Oberfläche durchgeführt, um die gewünschte Oberflächenform zu erhalten.

Durch diese Schritte verringert sich die Dicke des Wafers. Vorteilhafterweise wird daher vor und nach der nasschemischen Behandlung die Dicke des Wafers gemessen, so dass der prozentuale Materialabtrag aufgrund der nasschemischen Behandlung bestimmt werden kann.

Die Dickenmessung kann hierbei durch eine Messung mittels eines Mikrometers erfolgen. Da z.B. aufgrund einer Textur oder Unebenheit des Halbleiterwafers die Dicke jedoch inhomogen sein kann, ist insbesondere eine an sich bekannte kapazitive Dickenmessung vorteilhaft. Ebenso ist es denkbar, den prozentualen Materialabtrag durch zwei Wägevorgänge und Berechnung des Differenzgewichts zu bestimmen.

Anschließend wird wie vorhergehend beschrieben die Dotierungsschicht in den Halbleiter eingebracht und der Parallelschichtwiderstand $R_P$ des Halbleiterwafers gemessen.

Der gemessene Basisschichtwiderstand wird nun aber abhängig von der gemessenen prozentualen Materialreduzierung des Halbleiterwafers gemäß folgender Formel 1 korrigiert:

$$R_{B,korr} = \frac{R_B}{1 - d_M/100} \qquad (1),$$

wobei $d_M$ der prozentuale Materialabtrag in [%] des Halbleiterwafers aufgrund der nasschemischen Behandlung ist, $R_B$ der gemessenen Basisschichtwiderstand in [Ω/□] und $R_{B,korr}$ der korrigierte Basisschichtwiderstand in [Ω/□].

Der Schichtwiderstand $R_D$ der eingebrachten Dotierungsschicht wird dementsprechend abhängig von dem gemessenen Parallelschichtwiderstand $R_P$ und dem korrigierten Basisschichtwiderstand $R_{B,korr}$ bestimmt.

In einer weiteren vorteilhaften Ausgestaltung des erfindungsgemäßen Verfahrens wird der Verfahrensschritt A nach Einbringen der Dotierungsschicht in den Halbleiterwafer durchgeführt und der Basisschichtwiderstand $R_B$ wird auf folgende Weise gemessen:

Zunächst wird der Teil des Halbleiterwafers mit der eindiffundierten Schicht abgetragen, vorzugsweise mittels mechanischer Verfahren, wie beispielsweise Schleifverfahren. Anschließend wird der Basisschichtwiderstand $R_B$ des verbleibenden Halbleiterwafers (der Basis) mittels des beschriebenen induktiven Messverfahrens gemessen. Vorteilhafterweise wird hierbei eine Dickenkorrektur des Basisschichtwiderstandes analog zu Formel 1 vorgenommen.

Dies stellt zwar eine zerstörende Messmethode dar, es kann aber dennoch Aufschluss über die zu erwartenden Emitterschichtwiderstände in einer Produktionslinie durch Durchführen solch eines Messverfahrens an Testwafern erhalten werden.

Vorteilhafterweise wird der Verfahrensschritt A nach Einbringen der Dotierungsschicht in den Halbleiterwafer jedoch derart durchgeführt, dass keine zerstörende Messung notwendig ist:

Hierzu werden nach Einbringen der Dotierungsschicht zwei induktive Messungen durchgeführt. Zum einen wird in Verfahrensschritt A anstelle des Basisschichtwiderstandes $R_B$ eine erste Messgröße $R_B$' gemessen. Ebenso wird in Verfahrensschritt B anstelle des Parallelschichtwiderstandes $R_P$ eine zweite Messgröße $R_P$' gemessen. Wesentlich ist, dass der Basisschichtwiderstand und der Schichtwiderstand der eingebrachten Dotierungsschicht einen unterschiedlich gewichteten Einfluss auf die beiden Messgrößen $R_B$' und $R_P$' haben.

Vorteilhafterweise wird die Messung derart durchgeführt, dass $R_B$' im Wesentlichen von dem Basisschichtwiderstand abhängt und $R_P$' im Wesentlichen von dem Schichtwiderstand der eingebrachten Schicht abhängt.

Mit induktiven Messverfahren ist es bisher nicht möglich, bei einer eindiffundierten Schicht mit einem nichtzerstörenden Verfahren ausschließlich den Schichtwiderstand der eindiffundierten Schicht unmittelbar zu messen. Es können jedoch zwei Messungen durchgeführt werden, wobei die Beiträge des Basisschichtwiderstandes des Wafers und des Schichtwiderstandes der eingebrachten Dotierschicht in den beiden Messungen unterschiedlich stark gewichtet werden. Idealerweise hängt die erste Messung wie oben beschrieben im Wesentlichen von dem Basisschichtwiderstand des Wafers und die zweite Messung im Wesentlichen von dem Schichtwiderstand der eingebrachten Dotierungsschicht ab.

Aus diesen beiden Messungen $R_B$' und $R_P$' kann auf den tatsächlichen Schichtwiderstand $R_D$ der eingebrachten Dotierungsschicht rückgeschlossen werden.

Ein höhere Genauigkeit wird erzielt, indem mindestens drei Messungen durchgeführt werden, wobei alle Messungen derart durchgeführt werden, dass die mindestens drei Messwerte jeweils unterschiedlich stark gewichtete Einflüsse aus dem Basisschichtwiderstand oder dem Schichtwiderstand der eingebrachten Dotierschicht aufweisen. In diesem Fall wird $R_D$ abhängig von den mindestens drei Messwerten berechnet.

Die vorhergehend beschriebenen Messgrößen $R_B$' und $R_D$' werden vorteilhafterweise durch ein induk-tives, tiefenauflösendes Messverfahren gemessen, wel-ches Schichtwiderstandsbeiträge aus unterschiedlichen Tiefen des Wafers (d.h. unterschiedlichen Abständen zur Oberfläche) unterschiedlich stark gewichtet.

Je nach Anwendungsfall kann es vorteilhaft sein, in Schritt B den Parallelschichtwiderstand $R_P$ nicht nur an einem Punkt, sondern an mindestens zwei ortsverschiedenen Punkten des Halbleiterwafers zu messen. Der Basisschichtwiderstand ist in der Regel homogen, so dass es ausreichen kann, ihn nur einmalig und an einem Messort zu messen. Entsprechend wird in Schritt C für jeden dieser ortsverschiedenen Punkte jeweils der Schichtwiderstand $R_D$ der Dotierungsschicht aus dem an den jeweiligen Punkten gemessenen Messwert $R_P$ und dem für alle Punkte identischen Messwert $R_B$ bestimmt.

Ebenso liegt es im Rahmen der Erfindung, an mindestens zwei ortsverschiedenen Messpunkten sowohl $R_B$, als auch $R_P$ zu messen und für jeden Messpunkt aus den dort gemessenen Werten $R_D$ zu bestimmen, um so beispielsweise eine ortsaufgelöste Messung des Schichtwiderstandes zu ermöglichen. Idealerweise stimmen die Messpunkte, an denen die Werte von $R_B$ und $R_P$ ermittelt werden, exakt überein. Es kann jedoch ausreichen und liegt im Rahmen der vorliegenden Erfindung, dass die Messpunkte, an denen die Werte $R_B$ und $R_P$ ermittelt werden, in benachbarten oder sich überlappenden Bereichen liegen.

Entsprechend kann lediglich eine Messung des prozentualen Materialabtrages durchgeführt und zur Korrektur gemäß Formel 1 benutzt werden. Ebenso liegt es im Rahmen der Erfindung, an jedem Messpunkt den (lokalen) prozentualen Materialabtrag zu bestimmen und entsprechend die Bestimmung von $R_D$ an jedem Messpunkt mit dem für diesen Punkt gemessenen prozentualen Materialabtrag zu korrigieren.

Hierdurch ist insbesondere rasterartig eine Messung an mehreren verschiedenen Ortspunkten möglich, so dass eine Topographie des Schichtwiderstandes $R_D$ erhalten wird und somit flächenaufgelöst Information über den Schichtwiderstand der Dotierungsschicht vorliegt.

Die induktive Messung des Schichtwiderstandes weist den Vorteil auf, dass eine berührungslose Messung erfolgt. Hierdurch ist die Integration des erfindungsgemäßen Verfahrens insbesondere in industrielle Produktionslinien in einfacher Weise möglich.

Eine typische induktive Messung des Schichtwiderstandes erfolgt derart, dass der zu messende Wafer in das Magnetfeld einer Spule gebracht wird. Die Spule ist an einen elektromagnetischen Schwingkreis angeschlossen und abhängig von der Dämpfung des Schwingkreises durch das Einbringen des Wafers wird der Schichtwiderstand bestimmt.

In einer Produktionslinie, in der eine Mehrzahl von Halbleiterwafern prozessiert wird, ist man aus Kosten- und Zeitgründen bestrebt, gegebenenfalls vorzu-nehmende Schichtwiderstandsmessungen auf ein not-wendiges Mindestmaß zu reduzieren. Gleichzeitig ist das Ausgangsmaterial hinsichtlich des Basisschichtwiderstandes in der Regel recht homogen, jedenfalls soweit es jeweils solche Halbleiterwafer betrifft, die aus einem Block stammen. Hier kann es vorteilhaft sein, das erfindungsgemäße Verfahren so umzusetzen, dass nur bei einer Teilmenge der Halbleiterwafer der Basisschichtwiderstand gemessen wird und dieser Messwert - gegebenenfalls nach einer Mittelung mehrerer Messungen - als Messwert $R_B$ zur Ermittlung des Schichtwiderstands $R_D$ der Dotierungsschicht an allen Wafern zugrundegelegt wird, deren Parallelwiderstand $R_P$ an einem oder mehreren Orten auf dem Wafer in Schritt B gemessen wurde. Die Teilmenge kann wiederum aus einer Mehrzahl, oder aber auch nur aus einem einzigen, stichprobenartig ausgewählten Halbleiterwafer bestehen.

Weitere vorteilhafte Ausgestaltungen des erfindungsgemäßen Verfahrens werden im Folgenden anhand der Figuren beschrieben. Dabei zeigt:

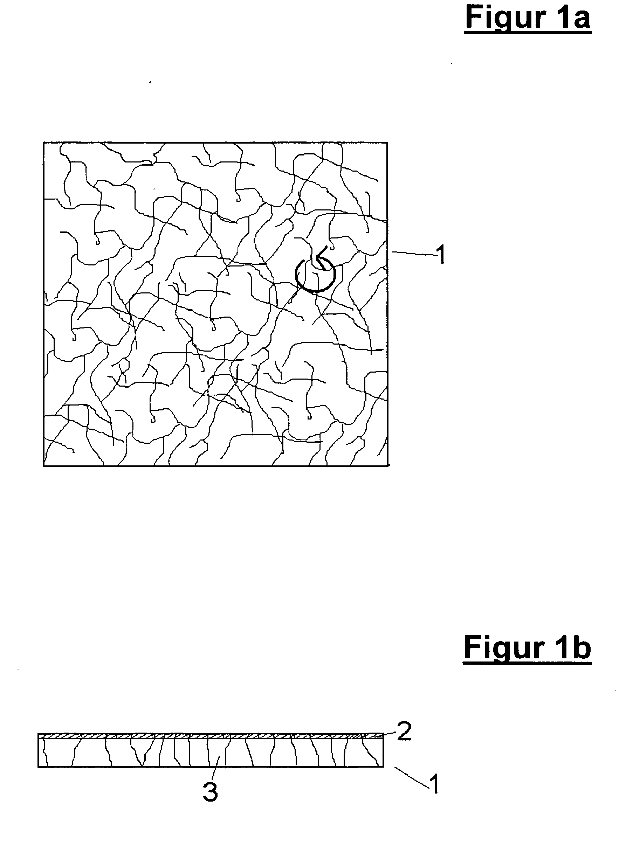

Figur 1 a    eine Draufsicht von oben und
Figur 1 b    einen Querschnitt eines multikristallinen Siliziumwafers mit eindiffundiertem Emitter zur Herstellung einer Solarzelle, sowie
Figur 2    ein Flussdiagramm, welches bei der Herstellung einer Solarzelle die Messung des Emitterschichtwiderstandes nach dem Stand der Technik (a) und gemäß eines Ausführungsbeispieles (b) des erfindungsgemäßen Verfahrens gegenübergestellt.

Typische multikristalline Siliziumwafer zur Herstellung von Solarzellen besitzen eine Kantenlänge von 125 mm bis 210 mm und eine Dicke von 100 $\mu$m bis 400 $\mu$m. Typischerweise ist der Wafer homogen p-dotiert. Ebenso ist jedoch auch die Verwendung von homogen n-dotierten Wafern bekannt.

Figur 1 a zeigt eine Draufsicht von oben auf einen typischen zur Herstellung von Solarzellen verwendeten multikristallinen Siliziumwafer in schematischer Darstellung. Der Wafer ist in etwa quadratisch und besitzt eine Kantenlänge von etwa 156 mm. Er besitzt eine Dicke von etwa 200 $\mu$m und ist homogen mit Bor dotiert, so dass eine homogene p-Dotierung der Basis vorliegt. Die Korngrenzen sind schematisch als Linien dargestellt.

In Figur 1b ist ein nicht maßstabsgetreuer Querschnitt des in Figur 1 a gezeigten Siliziumwafers 1 dargestellt.

In den Wafer wurde bereits eine schraffiert dargestellte n-dotierte Schicht eingebracht, welche den Emitter 2 der späteren Solarzelle bildet.

Für die Emitterdotierung wurde Phosphor verwendet, wobei der Emitter aus einer eindiffundierten Schicht von etwa 1 $\mu$m Dicke besteht. Typische Emitter weisen Dicken zwischen 0.1 $\mu$m und 1.2 $\mu$m auf.

Aufgrund der p-dotierten Basis 3 und des n-dotierten Emitters 2 entsteht somit zwischen Basis und Emitter ein pn-Übergang, welcher die bei der Solarzelle erwünschte Trennung der Ladungsträger in dem Halbleiterwafer bewirkt.

In den Figuren 1 a und 1 b sind ferner schematisch Korngrenzen der einzelnen Körner des multikristallinen Silizium dargestellt, an denen sich - wie vorhergehend beschrieben - zwischen nasschemischer Behandlung des Siliziumwafers 1 und Eindiffundieren des Emitters 2 Potentialbarrieren aufbauen können, welche zu einer Verfälschung einer Messung des Schichtwiderstandes nach dem herkömmlichen Messverfahren führen.

Der kreisartige Pfeil in Figur 1 a zeigt schematisch einen bei der induktiven Messung erzeugten Wirbelstrom an, welcher parallel zur Oberfläche des Wafers fließt, d.h. in Figur 1a in der Zeichenebene liegend.

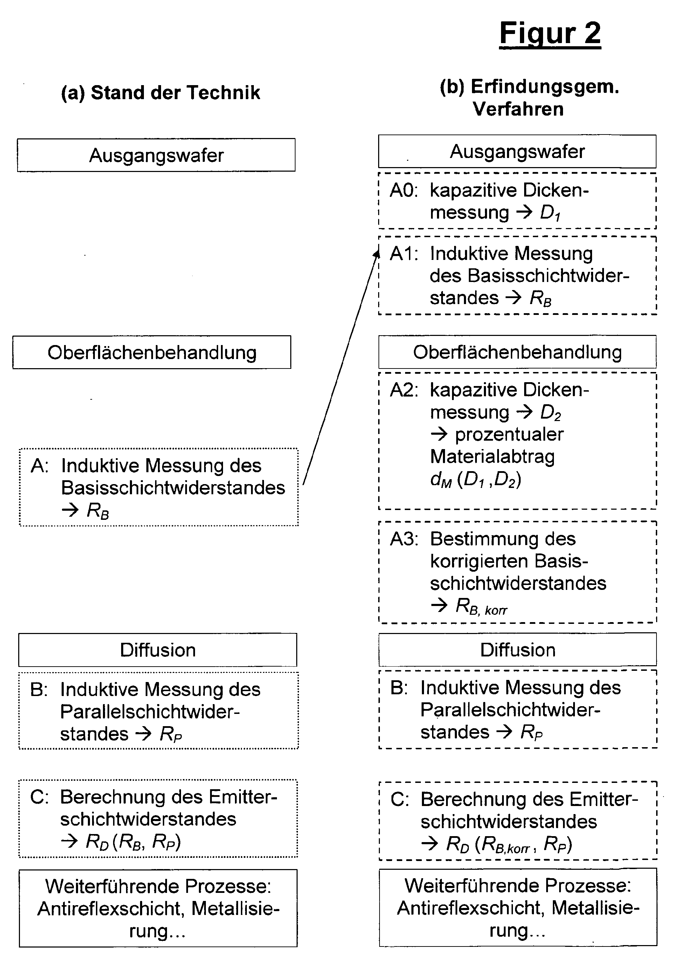

In Figur 2 sind zwei Ablaufdiagramme gegenübergestellt, bei denen die Einbettung des Verfahrens zur Messung eines Schichtwiderstandes in den Herstellungsprozess einer Solarzelle aufgezeigt ist.

In der linken Spalte (a) ist das Vorgehen gemäß Stand der Technik dargestellt, wohingegen die rechte Spalte (b) ein Ausführungsbeispiel des erfindungsgemäßen Verfahrens darstellt.

Wie in Spalte (a) ersichtlich, wird bei der Herstellung einer Solarzelle ausgehend von einem Ausgangswafer zunächst eine Oberflächenbehandlung vorgenommen und anschließend in einem Diffusionsschritt der Emitter in den Wafer eingebracht, worauf schließlich weiterführende Prozessschritte erfolgen, wie das Aufbringen der Antireflexschicht und die Metallisierung der Solarzelle, typischerweise durch Vorder- und Rückseitenkontakte.

Der Ausgangswafer stellt einen wie zuvor beschriebenen multikristallinen Siliziumwafer dar.

Gemäß Stand der Technik wurde nach der Oberflächenbehandlung eine induktive Messung des Basiswiderstandes $R_P$ durchgeführt und nach Diffusion des Emitters wurde durch induktive Messung der Parallelschichtwiderstand $R_P$ gemessen.

Anschließend wurde der Emitterschichtwiderstand $R_D$ abhängig von $R_B$ und $R_P$ berechnet.

Wie zuvor beschrieben, bewirkt die Oberflächenbehandlung des Wafers jedoch, dass sich insbesondere an den Korngrenzen des multikristallinen Siliziumwafers Potentialbarrieren ausbilden können, so dass die Basisschichtwiderstandsmessung in Schritt A einen zu hohen Schichtwiderstand für die Basis ergibt und entsprechend in Schritt C ein fehlerhafter Emitterschichtwiderstand berechnet wird.

In Spalte (b) ist die Einbettung des Ausführungsbeispiels des erfindungsgemäßen Verfahrens zur Messung des Schichtwiderstandes in den Herstellungsprozess der Solarzelle aufgezeigt:

Hierbei wird am Ausgangswafer zuerst in einem Schritt A0 eine erste kapazitive Dickenmessung durchgeführt welche die (gemittelte) Dicke $D_1$ des Wafers ergibt. Bei typischen multikristallinen Siliziumwafern kann diese Dicke beispielsweise 240 $\mu$m betragen.

Anschließend wird in Verfahrensschritt A1 der Basisschichtwiderstand $R_B$ des Ausgangswafers mittels induktiver Messung gemessen.

Wesentlich ist, dass Verfahrensschritt A1 vor der Oberflächenbehandlung, d.h. vor der nasschemischen Behandlung des Wafers stattfindet, so dass bei dem erfindungsgemäßen Verfahren die Messung in Verfahrensschritt A1 nicht oder zumindest nur vernachlässigbar gering durch Potentialbarrieren an den Korngrenzen verfälscht wird.

Nach der Oberflächenbehandlung wird in einem Verfahrensschritt A2 eine zweite kapazitive Dickenmessung durchgeführt, welche die (gemittelte) Dicke $D_2$ des Wafers nach der Oberflächenbehandlung ergibt. Typischerweise ist die Dicke durch die nasschemische Behandlung um etwa 20 $\mu$m verringert, d.h. $D_2$ beträgt in etwa 220 $\mu$m.

Anschließend wird der prozentuale Materialabtrag $d_M$ gemäß Formel 2

$$d_M = 100\left(1 - \frac{D_2}{D_1}\right) \qquad (2)$$

berechnet, mit der ersten gemessenen Dicke $D_1$ in [$\mu$m] und der zweiten gemessenen Dicke $D_2$ in [$\mu$m]. Alternativ kann der prozentuale Materialabtrag. auch z.B. durch reine Gewichtsmessung vor und nach dem Ätzvorgang bestimmt werden.

Anschließend wird in einem Schritt A3 der korrigierte Basisschichtwiderstand $R_{B,korr}$ anhand der bereits zuvor angegebenen Formel 1 abhängig von dem gemessenen Basisschichtwiderstand $R_B$ und dem prozentualen Materialabtrag $d_M$ berechnet.

Nun erfolgt das Einbringen der Dotierungsschicht, indem an einer Oberfläche des Siliziumwafers Phosphor eindiffundiert wird, so dass der Emitter 2 entsteht.

Wie zuvor beschrieben, bewirkt der Diffusionsschritt zusätzlich, dass die Potentialbarrieren an den Korngrenzen des multikristallinen Siliziumwafers 1 abgebaut werden und keinen Einfluss mehr auf den Schichtwiderstand bewirken.

Nach Diffusion des Emitters wird in einem Verfahrensschritt B der Parallelschichtwiderstand $R_P$ mittels induktiver Schichtwiderstandsmessung gemessen.

Dieser gemessene Parallelschichtwiderstand ist sowohl von dem Schichtwiderstand des Emitters, als auch von dem Schichtwiderstand der Basis beeinflusst.

In einem Schritt C wird gemäß folgender Formel 3 der Schichtwiderstand $R_D$ aus dem Parallelschichtwiderstand $R_P$ und dem korrigierten Basisschichtwiderstand $R_{B,korr}$ berechnet:

$$R_D = \frac{R_{B,korr} \cdot R_P}{R_{B,korr} - R_P} \qquad (3),$$

wobei alle Werte die Einheit [$\Omega/\square$] besitzen.

Anschließend werden weitere Prozessschritte zur Herstellung der Solarzelle vorgenommen, wie beispielsweise das Aufbringen einer Antireflexschicht und von Metallisierungsstrukturen, insbesondere von Vorder- und Rückseitenkontakten.

Die obige Formel 3 ist für den Fall anwendbar, dass lediglich an einer Oberfläche des Halbleiterwafers ein Emitter eingebracht wird. Werden auf beiden Oberflächen des Halbleiterwafers in etwa identische Emitter eingebracht (beispielsweise bei einer Rohrofendiffusion), so kann der Emitterschichtwiderstand aus Formel 4

$$R_D = 2\frac{R_{B,korr} \cdot R_P}{R_{B,korr} - R_P} \qquad (4)$$

berechnet werden, mit identischen Größen und Einheiten wie bei Formel 3.

Im Falle einer beidseitigen Diffusion wird der Emitter in einem nachfolgenden Prozessschritt auf einer Seite wieder entfernt oder mit einem elektrisch entgegengesetzten Dotierstoff überkompensiert.

Mit dem erfindungsgemäßen Ausführungsbeispiel ist somit erstmals mit der induktiven Messmethode eine exakte Bestimmung des Emitterschichtwiderstandes insbesondere bei der Herstellung von Solarzellen auf multikristallinen Siliziumwafern möglich. Darüber hinaus stellt das Messverfahren aufgrund der Verwendung einer induktiven Messmethode ein nicht-zerstörendes und berührungsfreies Messverfahren dar und ist in einfacher Weise in eine industrielle Produktionslinie integrierbar.

Sofern keine Korrektur aufgrund eines Materialabtrages erfolgen soll (z.B. wenn kein Materialabtrag stattfindet), wird der Schichtwiderstand $R_D$ der eingebrachten Dotierungsschicht abhängig von dem unkorrigierten Basisschichtwiderstand $R_B$ berechnet, d.h. in Formel 3 oder Formel 4 wird anstelle von $R_{B,kor}$ der Wert $R_B$ eingesetzt.

Vorangegangen wurde die Bestimmung des Schichtwiderstandes $R_D$ der in den Halbleiterwafer eingebrachten Dotierungsschicht beschrieben. Ebenso liegt es jedoch im Rahmen der Erfindung, anstelle des Schichtwiderstandes hiermit direkt zusammenhängende Größen wie beispielsweise die Dotierung der eingebrachten Schicht (d.h. die Anzahl der eingebrachten Dotieratome pro Volumeneinheit) in [1/cm$^3$] oder den spezifischen Widerstand der eingebrachten Schicht in [$\Omega$ cm] zu bestimmen. Ebenso liegt es im Rahmen der Erfindung, wenn als Messwerte $R_B$ und $R_P$ keine Schichtwiderstände, sondern damit direkt zusammenhängende Größen ermittelt werden, wie beispielsweise die Dotierung der eingebrachten Schicht (d.h. die Anzahl der eingebrachten Dotieratome pro Volumeneinheit) in [1/cm$^3$] oder den spezifischen Widerstand der eingebrachten Schicht in [$\Omega$ cm].

**Patentansprüche**

1. Verfahren zur induktiven Messung eines Schichtwiderstandes einer in einen multikristallinen Halbleiterwafer (1) eingebrachten Dotierungsschicht (2), insbesondere einer in einen multikristallinen Siliziumwafer eingebrachten Dotierungsschicht, folgende Verfahrensschritte umfassend:

A Bestimmen des Basisschichtwiderstandes $R_B$ des Halbleiterwafers (1) mittels einer induktiven Messmethode,
B Bestimmen des Parallelschichtwiderstandes $R_P$ des Halbleiterwafers (1) mittels einer induktiven Messmethode, nachdem die Dotierungsschicht (2) eingebracht wurde,
C Berechnen des Schichtwiderstandes $R_D$ der eingebrachten Dotierungsschicht (2) abhängig von $R_B$ und $R_P$,

**dadurch gekennzeichnet,**
**dass** der Verfahrensschritt A

- vor Einbringen der Dotierungsschicht (2) und vor einer Behandlung des Halbleiterwafers (1), welche Potentialbarrieren an den Korngrenzen erzeugen kann, durchgeführt wird und/oder
- nach Einbringen der Dotierungsschicht (2) in den Halbleiterwafer (1) durchgeführt wird.

**2.** Verfahren nach Anspruch 1,
**dadurch gekennzeichnet,**
**dass** der Verfahrensschritt A vor Einbringen der Dotierungsschicht (2) und vor einer nasschemischen Behandlung des Halbleiterwafers (1), vor einem Ätzprozess an dem Halbleiterwafer oder vor einem Reinigungsprozess an dem Halbleiterwafer durchgeführt wird.

**3.** Verfahren nach einem der Ansprüche 1 bis 2,
**dadurch gekennzeichnet,**
**dass** der Verfahrensschritt A vor Einbringen der Dotierungsschicht (2) und vor einer Behandlung des Halbleiterwafers (1), welche Potentialbarrieren an den Korngrenzen erzeugen kann, durchgeführt wird und
**dass** in Verfahrensschritt C der Schichtwiderstand $R_D$ der eingebrachten Dotierungsschicht zusätzlich abhängig von einem zwischen Verfahrensschritt A und Verfahrensschritt B erfolgten Materialabtrages an dem Halbleiterwafer korrigiert wird.

**4.** Verfahren nach Anspruch 3,
**dadurch gekennzeichnet,**
**dass** bei der Behandlung des Halbleiterwafers (1) zwischen Verfahrensschritt A und Verfahrensschritt B der prozentuale Materialabtrag $d_M$ des Halbleiterwafers (1) bestimmt wird und in Verfahrensschritt C der Schichtwiderstand $R_D$ abhängig von dem gemessenen Parallelschichtwiderstand $R_P$ und abhängig von einem korrigierten Basisschichtwiderstand $R_{B,korr}$ bestimmt wird, wobei sich $R_{B,korr}$ aus Formel 1

$$R_{B,korr} = \frac{R_B}{1 - d_M/100} \qquad (1)$$

berechnet, mit dem prozentualen Materialabtrag $d_M$ in [%] und dem in Verfahrensschritt A gemessenen Basisschichtwiderstand $R_B$ in [$\Omega/\square$].

**5.** Verfahren nach Anspruch 1,
**dadurch gekennzeichnet,**
**dass** der Verfahrensschritt A nach Einbringen der Dotierungsschicht in den Halbleiterwafer (1) durchgeführt wird und
**dass** der Basisschichtwiderstand $R_B$ gemessen wird, indem zunächst der Teil des Halbleiterwafers mit der eindiffundierten Schicht (2) abgetragen wird und anschließend der Basisschichtwiderstand $R_B$ des verbleibenden Halbleiterwafers (3) bestimmt wird.

**6.** Verfahren nach Anspruch 1,
**dadurch gekennzeichnet,**
**dass** der Verfahrensschritt A nach Einbringen der Dotierungsschicht (2) in den Halbleiterwafer (1) durchgeführt wird,
**dass** in Verfahrensschritt A als Basisschichtwiderstand $R_B$ ein erster Messwert $R_B'$ gemessen wird,
**dass** in Verfahrensschritt B als Parallelschichtwiderstand $R_P$ ein zweiter Messwert $R_P'$ gemessen wird, wobei die Messung des ersten und des zweiten Messwertes derart ausgeführt wird, dass der erste Messwert $R_B'$ stärker von dem Schichtwiderstand der eingebrachten Dotierungsschicht (2) beeinflusst ist als $R_P'$ und der zweite Messwert $R_P'$ stärker von dem Schichtwiderstand der Basis (3) beeinflusst ist als $R_B'$ und
**dass** in Verfahrensschritt C der Schichtwiderstand $R_D$ der eingebrachten Dotierungsschicht (2) aus $R_B'$ und $R_D'$ bestimmt wird.

**7.** Verfahren nach Anspruch 6,
**dadurch gekennzeichnet,**
**dass** $R_B'$ und $R_D'$ jeweils durch ein tiefenaufgelöstes, induktives Messverfahren bestimmt werden.

**8.** Verfahren nach einem der Ansprüche 6 und 7,
**dadurch gekennzeichnet,**
**dass** mindestens drei Messwerte mit jeweils unterschiedlicher Gewichtung der Einflüsse der Schichtwiderstände von Basis und eingebrachter Dotierungsschicht gemessen werden und
**dass** in Verfahrensschritt C der Schichtwiderstand $R_D$ der eingebrachten Dotierungsschicht aus mindestens den drei Messwerten bestimmt wird.

**9.** Verfahren nach mindestens einem der vorangegangenen Ansprüche,
**dadurch gekennzeichnet,**
**dass** in Verfahrensschritt A der Basisschichtwiderstand $R_B$ an einem Punkt des Halbleiterwafers gemessen wird, während in Verfahrensschritt B der Parallelschichtwiderstand $R_P$ an mindestens zwei ortsverschiedenen Punkten des Halbleiterwafers gemessen wird,
und **dass** in Verfahrensschritt C für jeden der Punkte jeweils der Schichtwiderstand $R_D$ der Dotierungsschicht aus dem an diesem Punkt gemessenen $R_P$ und dem $R_B$ bestimmt wird.

10. Verfahren nach mindestens einem der Ansprüche 1 bis 8
**dadurch gekennzeichnet**
**dass** in Verfahrensschritt A der Basisschichtwiderstand $R_B$ an mindestens zwei ortsverschiedenen Punkten des Halbleiterwafers gemessen wird,
und in Verfahrensschritt B der Parallelschichtwiderstand $R_P$ an mindestens zwei ortsverschiedenen Punkten des Halbleiterwafers gemessen wird,
und **dass** in Verfahrensschritt C für jeden der Punkte jeweils der Schichtwiderstand $R_D$ der Dotierungsschicht aus dem an diesem Punkt gemessenen $R_P$ und dem an diesem Punkt oder in dessen Umgebungsbereich gemessenen $R_B$ bestimmt wird.

11. Verfahren nach einem der Ansprüche 9 oder 10,
**dadurch gekennzeichnet,**
**dass** der Parallelschichtwiderstand $R_P$ und/oder der Basisschichtwiderstand $R_B$ rasterartig an mehreren ortsverschiedenen Punkten auf dem Halbleiterwafer gemessen werden.

12. Verfahren nach mindestens einem der Ansprüche 1 bis 11,
**dadurch gekennzeichnet,**
**dass** eine Mehrzahl von gleichartigen Halbleiterwafern gemessen wird, wobei der Verfahrensschritt A an nur einer Teilmenge der Halbleiterwafer durchgeführt wird.

13. Verfahren nach mindestens einem der vorangegangenen Ansprüche,
**dadurch gekennzeichnet,**
**dass** der Schichtwiderstand **dadurch** gemessen wird, dass der Halbleiterwafer in ein Magnetfeld einer Spule eines elektromagnetischen Schwingkreises eingebracht wird und abhängig von der Dämpfung des Schwingkreises nach Einbringen des Halbleiterwafers der Schichtwiderstand bestimmt wird.

## Figur 1a

1

## Figur 1b

2

3

1

# Figur 2

## (a) Stand der Technik

| Ausgangswafer |
|---|

| Oberflächenbehandlung |
|---|

A: Induktive Messung des Basisschichtwiderstandes → $R_B$

| Diffusion |
|---|

B: Induktive Messung des Parallelschichtwiderstandes → $R_P$

C: Berechnung des Emitterschichtwiderstandes → $R_D (R_B, R_P)$

| Weiterführende Prozesse: Antireflexschicht, Metallisierung... |
|---|

## (b) Erfindungsgem. Verfahren

| Ausgangswafer |
|---|

A0: kapazitive Dickenmessung → $D_1$

A1: Induktive Messung des Basisschichtwiderstandes → $R_B$

| Oberflächenbehandlung |
|---|

A2: kapazitive Dickenmessung → $D_2$ → prozentualer Materialabtrag $d_M (D_1 ,D_2)$

A3: Bestimmung des korrigierten Basisschichtwiderstandes → $R_{B, korr}$

| Diffusion |
|---|

B: Induktive Messung des Parallelschichtwiderstandes → $R_P$

C: Berechnung des Emitterschichtwiderstandes → $R_D (R_{B,korr}, R_P)$

| Weiterführende Prozesse: Antireflexschicht, Metallisierung... |
|---|

**IN DER BESCHREIBUNG AUFGEFÜHRTE DOKUMENTE**

**In der Beschreibung aufgeführte Nicht-Patentliteratur**

- **D. K. SCHRODER.** Semiconductor material and device characterization. John Wiley & Sons, 1990, 27-30